# EUROPEAN PATENT APPLICATION

(11) **EP 1 014 515 A2**
(43) Date of publication of application: **28.06.2000**
(21) Application number: 99500221.9
(22) Date of filing: 25.11.1999
(51) Int. Cl.: H01R 43/02

(54) **Method for the ultrasonic multidirectional interconnection of flat cables**

(30) Priority: 18.12.1998 ES 9802629
(71) Applicant: Mecanismos Auxiliares Industriales S.L., 43800 Valls, Tarragona (ES)
(72) Inventor: Saez Garcia, Ana, 43800 Valls, Tarragona (ES)
(74) Representative: Morgades Manonelles, Juan Antonio

(57) **Abstract**

The invention relates to a method by which flat cables, of those formed with an insulating sheat and flat copper leads at its interior, may be connected with other ones of same nature by the ultrasonic welding which allows the vaporization of the insulating portion, the fusion of the conductive portion of copper sheets integrating same, without harming the conductivity mandatory conditions.

## Description

The present application for a Patent of Invention consists, as indicated in its title, in a "METHOD FOR THE ULTRASONIC MULTIDIRECTIONAL INTERCONNECTION OF FLAT CABLES", which novel characteristics of manufacturing, shaping and design fullfill the object for which had been specifically designed with a maximum of safety and efficiency.

More particularly the invention relates to a method by which flat cables, of those formed with an insulating sheat and flat copper leads at its interior, may be connected with other ones of same nature by the ultrasonic welding which allows the vaporization of the insulating portion, the fusion of the conductive portion of copper sheets integrating same, without harming the conductivity mandatory conditions.

There exist in the market and therefore can be considered the State of the Art a plurality of flat cables which contain a plurality of leads, also flat, arraged longitudinally and in parallel and as a consecuence of forming a part of a complex electrical installation, preferably in the automobile field, need their connection when crossing with others of same nature in any type of direction, which is carried out by the provision of small staples which when punching the insulating portion, penetrate until the contact is estabilished with the conductive portion of said cable, being estabilished in this way the contact between the different leads forming the flat cables.

Anyhow, the experience shows that in some cases and as a consecuence of a lack of precission in the placement of the staples as well as the pressure of same on the conductive element, the connection is not estabilished with the necesary conductive values and is the cause of multiple problems, therefore this method that can be considered conventional is substituted for what is the object of the present invention consisting in the peeling of the cable, i. e., the selective elimination of a portion of the insulating sheat by a source of light such as either a laser equipment applied to both faces of the cable, or by cutting with knives or a similar method, which is made separately over the cable portons that are to be put into contact.

In the second place and once obtained the selective peeling of the insulating portion of said cables at the zones where they must be joined with others, these are situated in such a way that the peeled portions of same are coincident, positioning them afterwards in such a way that the uncovered conductive portions are kept superimposed for producing, in the last operation, the welding of the conductive portions of said cables in the peeled zones by ultrasonic means.

Other details and characteristics of the present application for a Patent of Invention will be manifest through the reading of the description given herebelow, in which reference is made to the figures attached to this description where the above details are depicted in a rather schematic way. These details are given as an example, referring to a case of a possible practical embodiment, but is not limited to the details outlined; therefore this description must be considered from an illustrative point of view and with no limitations whatsoever.

There follows a detailed report of the several elements named in the present application: (10) flat cable, (11) insulating sheat, (11.1) sheet, (11.2) sheet, (12) flat leads, (13) flat cable, (14) cable, (15) sheat, (16) sheat, (17) conductive portion, (17.1) peeled zone, (18) conductive portion, (18.1) peeled zone.

Figure 1 is an upper plan view of a flat cable (10).

Figure 2 is a section by 2-2 as per Figure 1.

Figure 3 is an schematic view of the procedure which utilizes the object of the present invention for producing the welding of flat cables.

Figure 4 is an elevation lateral view, partially cut, of the union between the conductive portions of two flat cables (13 and 14).

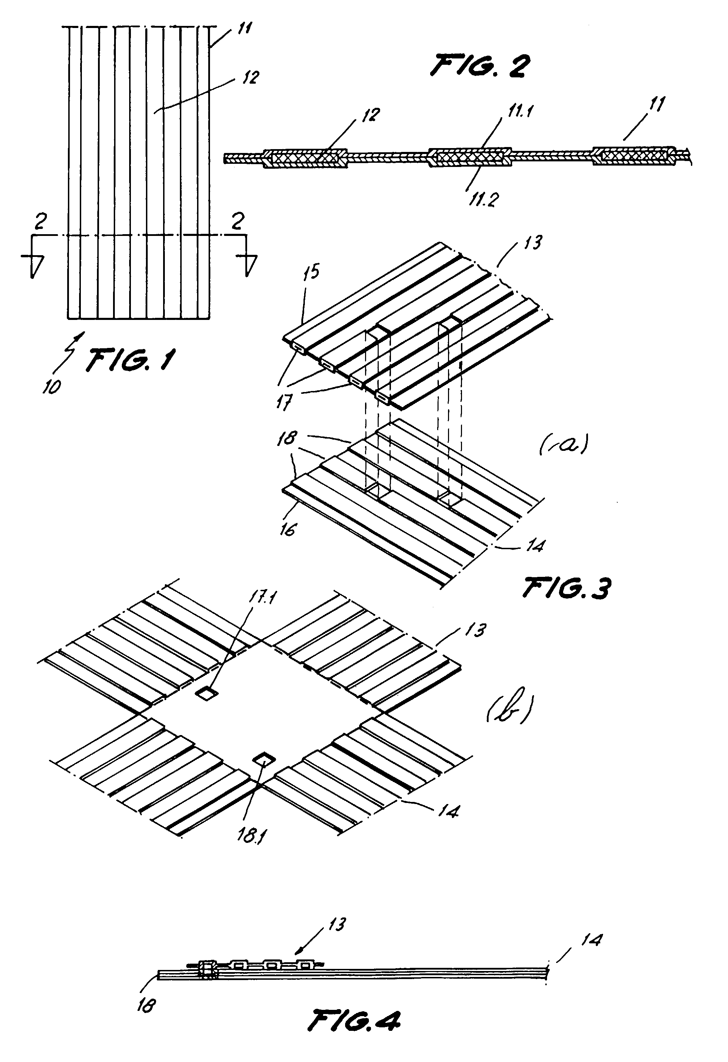

In one of the preferred embodiments of what is the object of the present application and as can be seen in Figure 1, a flat cable (10) is formed basically with an insulating sheat (11) among which are found several copper or similar material flat leads arranged in parallel and covered with said sheat (11) formed with two sheets (11.1 and 11.2).

The proposed method consists in obtaining the electric union between two or more cables of those shown in Figure 1, in order to that and as can be seen in Figure 3, one proceeds by a source of luminic energy, such as a laser source or similar, to the selective fusion of the sheat protions (15 and 16) of cables wich conductive portions (17 and 18) are to be joined.

Afterwards and once achieved the fusion of the insulating sheat at both faces in the zones (17.1 and 18.1) one proceeds to the fusion, fixation and welding of the uncovered conductive portions by an ultrasonic source allowing the electric union by fusion at said zones (17.1 and 18.1), as can be seen in the Figures 3 and 4.

The proposed method will allow the multidirectional interconnection of flat cables (10), even if those shown in Figure 3, in order to a better understanding of the invention, have been shown crossing ortogonally, but the welding and proposed method can be utilized for cables (10) crossing in any direction, as well as for two or more flat cables of the type shown in Figure 1, being possible with the proposed method reaching a high performance index as a consequence of being able to arrange said cables in working benches or tables and therefore reaching several configuration types allowing the union of a plurality of cables at which ends will be provided other electric components, such as terminals, connectors, relays, lamps and any tipe of electric components of those used in the automotive sector, and also the flat cables may be formed with three or more conductive leads (12), even if those shown in the Figures have only three.

Enough disclosed what the present application for a Patent of Invention is in agreement with the attached figures, it s understood that can be introduced in same any detail modifications regarded as convenient, always provided that any the modifications entered do not depart from the essence of the present Patent of Invention as summarized in the following claim.

## Claims

1. "METHOD FOR THE ULTRASONIC MULTIDIRECTIONAL INTERCONNECTION OF FLAT CABLES" of those formed with an insulating sheat (11) arranged in two sheets (11.1 and 11.2) welded between the and housing between same flat copper, aluminium or similar material leads (12), which are arranged longitudinally and are parallel among them, characterized in that two or more flat cables (10) can be electrically connected carrying out previously the following operations:
- a) Selective peeling of the cables (10) with the help either of a luminic energy source, such as a laser device, at both faces at the same time but separately, or cutting with knives or a similar operation.
- b) Spatial placement of the cables (10) ones on top of the others, facing the sheat peeled portions (17.1 and 18.1).
- c) Welding by an ultrasonic source of the copper conductive portions peeled.
